# EUROPÄISCHE PATENTSCHRIFT

(11) **EP 1 435 132 B1**
(45) Veröffentlichungstag und Bekanntmachung des Hinweises auf die Patenterteilung: **09.04.2008**
(21) Anmeldenummer: 02772191.9
(22) Anmeldetag: 22.08.2002
(51) Int. Cl.: H03H 9/58

(54) **PIEZOELEKTRISCHES BAUELEMENT UND VERFAHREN ZU DESSEN HERSTELLUNG**
PIEZO-ELECTRICAL COMPONENT AND METHOD FOR PRODUCTION THEREOF
COMPOSANT PIEZO-ELECTRIQUE ET SON PROCEDE DE PRODUCTION

(30) Priorität: 25.09.2001 DE 10147075
(43) Veröffentlichungstag der Anmeldung: 07.07.2004
(73) Patentinhaber: Infineon Technologies AG, 81669 München (DE)
(72) Erfinder: AIGNER, Robert, 81675 München (DE); MARKSTEINER, Stephan, 85640 Putzbrunn (DE); NESSLER, Winfried, 81739 München (DE)
(74) Vertreter: Ginzel, Christian
(86) Internationale Anmeldenummer: PCT/EP2002/009406
(87) Internationale Veröffentlichungsnummer: WO 2003/030358

(56) Entgegenhaltungen:
- US-A- 5 382 930
- US-A- 5 821 833
- US-A- 5 864 261

## Beschreibung

Die vorliegende Erfindung betrifft piezoelektrische Bauelemente, die zumindest zwei Stacked-Crystal-Filter umfassen, sowie ein Verfahren zur Herstellung derartiger piezoelektrischer Bauelemente.

Mit der immer weiter zunehmenden Verbreitung der mobilen Kommunikation und Datenübertragung besteht auch ein immer größer werdendes Interesse an der Entwicklung von Filtern und Resonatoren für Schmalbandanwendungen mit hoher Sperrbanddämpfung. Filter für GPS-Geräte (Global Positioning System), die eine 10 MHz Bandbreite bei 1,57 GHz aufweisen, oder Resonatoren für Frequenznormale sind Beispiele für derartige Anwendungen.

Eine hohe Sperrbanddämpfung wird üblicherweise durch die Verwendung von mehrstufigen Filtern erreicht, in denen beispielsweise frequenzverschobene Serien- und Shunt-Resonatoren in einer sogenannten "Leiterstruktur" verschaltet sind. Mit diesen mehrstufigen Filtern kann zwar eine nahezu optimale Bandbreite des Durchlassbereichs erreicht werden, für eine hohe Sperrbanddämpfung (Fernab-Selektion) ist jedoch eine sehr große Stufenanzahl notwendig, da die typische Sperrbanddämpfung pro Stufe in diesen Filtern bei nur ca. 6,8 dB liegt. Deshalb sind derzeit mehrstufige Filter, die eine Leiterstruktur aufweisen und eine Sperrbanddämpfung von mehr als 50 dB besitzen, praktisch nicht herstellbar.

Eine höhere Sperrbanddämpfung pro Filterstufe kann mit sogenannten "balanced"-Filtern erreicht werden, die in der Regel eine Brückenschaltung frequenzverschobener Resonatoren aufweisen. Die Verwendung dieser Filtertypen unterliegt jedoch einigen wesentlichen Einschränkungen. So müssen in "balanced"-Filtern das Eingangs- und Ausgangssignal differentiell (balanced) vorliegen. Systeme, in denen solche Filtertypen zum Einsatz kommen, erfordern deshalb entweder spezielle Antennen und Vorverstärker oder aber besondere Bauelemente oder Baugruppen, welche die üblicherweise vorliegenden, sogenannten "single-ended" Signale in sogenannte "balanced" Signale umwandeln.

Die derzeit am Markt befindlichen Filter und Resonatoren für Schmalbandanwendungen sind überwiegend keramische Filter oder sogenannte "Surface-Acoustic-Wave-Filter". Diese Filtertypen lassen sich allerdings nur schwer miniaturisieren und ihre Herstellung ist in der Regel aufwendig und damit kostenintensiv. Dies macht sie zur Verwendung in Niedrigpreis-Produkten ungeeignet. Darüber hinaus lassen sich diese Filterstrukturen in der Regel nicht in die üblichen Prozesse der Halbleiterfertigung integrieren.

Neben Surface-Acoustic-Wave-Filtern wird auch zunehmend versucht, sogenannte "Bulk-Acoustic-Wave" Filter als miniaturisierte Filter zu verwenden und diese mittels Dünnfilmtechniken auf Substraten herzustellen. Eine Untergruppe dieser Filtertypen sind die sogenannten "Stacked-Crystal-Filter" (SCF). Ein Stacked-Crystal-Filter umfaßt typischerweise zwei piezoelektrische Schichten und drei Elektroden. Die erste piezoelektrische Schicht ist zwischen einer ersten, unteren Elektrode und einer zweiten, mittleren Elektrode angeordnet, eine zweite piezoelektrische Schicht zwischen der zweiten, mittleren Elektrode und einer oberen, dritten Elektrode. Die mittlere Elektrode ist dabei in der Regel geerdet. Um zu verhindern, dass sich die in den piezoelektrischen Schichten erzeugten akustischen Schwingungen in dem Substrat ausbreiten, können die Stacked-Crystal-Filter beispielsweise durch akustische Spiegel von dem restlichen Substrat abgeschirmt werden.

Das Prinzip der Stacked-Crystal-Filter ist seit ungefähr 40 Jahren bekannt, konnte sich aber im MHz-Frequenzbereich großtechnisch nicht durchsetzten, da die Herstellung von entsprechenden Quarzplättchen mit Mittenelektroden nicht beherrscht war. Mit dem Fortschritt der Miniaturisierungstechnik, insbesondere dem Fortschritt in der Dünnfilmtechnik für Piezoschichten, gewinnen die Stacked-Crystal-Filter wieder zunehmend an Attraktivität. Ein entsprechender Filter für GPS-Anwendungen ist z.B. in "Stacked Crytal Filters Implemented with Thin Films, K.M. Lakin, G.R. Kline, R.S. Ketcham, J.T. Martin, K.T. McCarron, 43re Annual Symposium on Frequency Control (1989), Seite 536 - 543" beschrieben. Weitere Beispiele für die Verwendung von miniaturisierten Stacked-Crystal-Filtern sind beispielsweise in den Patentschriften US 5,910,756 und US 5,872,493 beschrieben. In letzterer wird weiterhin beschrieben, dass ein Stacked-Crystal-Filter über einen oberen und unteren akustischen Spiegel von dem Substrat akustisch abgeschirmt werden kann. Bekannt ist aus US-A-5 864 261 auch eine Stacked-Crystal-Filteranordnung, in der zwei ansonsten separate Stacked-Crystal-Filter durch eine aus einer Schicht gebildeten gemeinsamen unteren Elektrode verbunden sind.

Allen dort beschriebenen Stacked-Crystal-Filtern ist jedoch gemeinsam, dass ihre Herstellung aufgrund ihres komplexen Aufbaus und der damit verbundenen hohen Anzahl abzuscheidender und zu strukturierender Schichten einen hohen Prozessaufwand erfordern, der die Herstellungskosten der Filter erhöht.

Der vorliegenden Erfindung liegt daher die Aufgabe zugrunde, piezoelektrische Bauelemente bereitzustellen, welche die oben beschriebenen Nachteile deutlich verringern bzw. ganz vermeiden. Insbesondere ist es die Aufgabe der vorliegenden Erfindung, piezoelektrische Bauelemente bereitzustellen, die mit einem relativ geringen Prozessaufwand hergestellt werden können.

Diese Aufgabe wird durch das Verfahren zur Herstellung eines piezoelektrischen Bauelements gemäß dem unabhängigen Anspruch 1 sowie dem piezoelektrischen Bauelement gemäß Anspruch 10 gelöst. Weitere vorteilhafte Ausführungsformen, Ausgestaltungen und Aspekte der vorliegenden Erfindung ergeben sich aus den abhängigen Patentansprüchen, der Beschreibung und den beiliegenden Zeichnungen.

Erfindungsgemäß wird ein Verfahren zur Herstellung eines piezoelektrischen Bauelements enthaltend zumindest zwei Stacked-Crystal-Filter bereitgestellt, das die folgenden Schritte umfasst:
a) ein Substrat wird bereitgestellt;
b) auf dem Substrat wird aus einer auf dem Substrat aufgebrachten ersten elektrisch leitfähigen Schicht zumindest eine untere Elektrode erzeugt;
c) auf dem Substrat wird zumindest im Bereich der unteren Elektrode ein Schichtstapel aufgebracht, der, beginnend mit der untersten Schicht, eine erste piezoelektrische Schicht, eine zweite elektrisch leitfähige Schicht, eine zweite piezoelektrische Schicht und eine dritte elektrisch leitfähige Schicht umfasst;
d) lediglich die dritte elektrisch leitfähige Schicht und ggf. die zweite piezoelektrische Schicht werden strukturiert, so dass zumindest zwei Stacked-Crystal-Filter erzeugt werden;
e) die dritte elektrisch leitfähige Schicht wird kontaktiert.

Die Reihenfolge der Verfahrensschritte d) und e) ist dabei nicht festgelegt. Die Kontaktierung der dritten elektrisch leitfähigen Schicht kann auch vor der Strukturierung der dritten elektrisch leitfähigen Schicht und ggf. der zweiten piezoelektrischen Schicht erfolgen.

Durch das Abscheiden des Schichtstapels über der unteren Elektrode und der anschließenden Strukturierung der oberen elektrisch leitfähigen Schicht und ggf. zweiten piezoelektrischen Schicht kann auf einfache Weise, mit einem Minimum an Prozessschritten, ein piezoelektrisches Bauelement erzeugt werden, das zumindest zwei Stacked-Crystal-Filter umfaßt, die über ihre untere und mittlere Elektrode direkt miteinander verbunden sind.

Dabei werden die mittleren Elektroden aus der zweiten elektrisch leitfähigen Schicht und die oberen Elektroden aus der dritten elektrisch leitfähigen Schicht erzeugt. Die beiden piezoelektrischen Schichten werden aus piezoelektrischen Materialien hergestellt, die mittels Dünnfilmtechniken aufgebracht werden können, und umfassen z.B. Zinkoxid (ZnO), Aluminiumnitrid (AlN) oder PZT (Bleizirkoniumtitanat). Es kann aber auch jedes andere geeignete piezoelektrische Material zu ihrer Herstellung verwendet werden.

Als Materialien für die elektrisch leitfähigen Schichten, aus denen die unteren, mittleren bzw. oberen Elektroden erzeugt werden, können z.B. Aluminium, Aluminiumenthaltende Legierungen, Wolfram, Molybdän oder Platin verwendet werden. Es kann aber auch jedes andere geeignete elektrisch leitfähige Material verwendet werden. Als Substratmaterial kann z.B. Silizium, GaAs oder Glas verwendet werden.

In einer bevorzugten Ausführungsform des erfindungsgemäßen Verfahrens wird in der zweiten piezoelektrischen Schicht zumindest eine Öffnungen erzeugt und die zweite elektrisch leitfähige Schicht zusätzlich kontaktiert. Die erzeugte Öffnung oder erzeugten Öffnungen können als Kontaktlöcher dienen, durch die in dem Bauelement die mittleren Elektroden, die aus der zweiten elektrisch leitenden Schicht erzeugt werden, mit einem vorgegebenen Potential verbunden werden können.

In einer weiteren bevorzugten Variante des erfindungsgemäßen Verfahrens wird vor dem Kontaktieren der dritten elektrisch leitfähigen Schicht die Resonanzfrequenz zumindest eines erzeugten Stacked-Crystal-Filters gemessen und gegebenenfalls in einem weiteren Schritt durch lokales Abätzen die Schichtdicke dritten elektrisch leitfähigen Schicht korrigiert. Durch diese Variante wird es möglich, die Prozessausbeute zu optimieren, da durch den Frequenzabgleich während des Strukturierungsverfahrens der sogenannte "Yield" werden kann. Dabei ist sowohl möglich, die Resonanzfrequenz eines bereits strukturierten Stacked-Crystal-Filters durch Veränderung der Schichtdicke der dritten elektrisch leitfähigen Schicht zu korrigieren, als auch eine Testmessung an einem oder mehreren Stacked-Crystal-Filtern, die beispielsweise am Rande des Substrats strukturiert wurden, als Anhaltspunkt zur Veränderung der Schichtdicke der dritten elektrisch leitfähigen Schicht in bisher unstrukturierten Bereichen zu verwenden, in denen erst in einem oder mehreren folgenden Verfahrensschritten Stacked-Crystal-Filter erzeugt werden. Weiterhin ist es selbstverständlich möglich, anstelle des lokalen Abätzens die Schichtdicke der dritten elektrisch leitfähigen Schicht durch weiteres Abscheiden von Material zu verändern und somit zu korrigieren.

In einer weiteren bevorzugten Variante des erfindungsgemäßen Verfahrens wird vor dem Strukturieren der dritten elektrisch leitfähigen Schicht sowie ggf. der zweiten piezoelektrischen Schicht und/oder dem Kontaktieren der dritten elektrisch leitfähigen Schicht zumindest ein oberer akustischer Spiegel erzeugt. Dieser wird vorzugsweise aus einem auf der dritten elektrisch leitfähigen Schicht aufgebrachten Schichtstapel erzeugt, wobei der Schichtstapel zumindest aus einer Schicht aus einem elektrisch leitfähigen Metall besteht. Besonders bevorzugt ist es, dass alle Schichten dieses Schichtstapels elektrisch leitfähig sind. Dadurch wird gewährleistet, dass der gesamte obere akustische Spiegel elektrisch leitfähig ist. Durch den oberen akustischen Spiegel werden die in dem Stacked-Crystal-Filter erzeugten akustischen Wellen reflektiert und so der SCF akustisch abgeschirmt. Die Erzeugung des oberen akustischen Spiegels aus einem elektrisch leitfähigen Metall ermöglicht eine besonders einfache Kontaktierung der oberen Elektroden, da diese über den oberen akustischen Spiegel erfolgen kann. Dies erleichtert darüber hinaus das sogenannte "packaging" des Bauelements, das dadurch beispielsweise durch eine sogenannte "Flip-Chip-Montage" ohne Zusatzmaßnahmen montiert werden kann.

In einer besonders bevorzugten Variante des erfindungsgemäßen Verfahrens wird der obere akustische Spiegel aus einer Schichtfolge von elektrisch leitfähigen Metallen mit abwechselnd hoher oder niedriger akustischer Impedanz erzeugt. Geeignete Metalle mit hoher akustischer Impedanz sind beispielsweise Gold (Au), Molybdän (Mo) oder Wolfram (W). Als Metalle mit niedriger akustischer Impedanz sind beispielsweise Aluminium (Al) oder Titan (Ti) geeignet.

Um die Stacked-Crystal-Filter auch nach unten gegenüber dem Substrat abzuschirmen, wird in einer bevorzugten Ausführungsform des erfindungsgemäßen Verfahrens vor der Erzeugung der unteren Elektrode ein unterer akustischer Spiegel in dem Substrat erzeugt. Dieser kann aus einer Membran, aus einem Hohlraum oder aus einer Schichtfolge von Schichten aus Materialien mit abwechselnd hoher und niedriger akustischer Impedanz erzeugt werden. Geeignete Materialien mit niedriger akustischer Impedanz sind beispielsweise Silizium (Si), Polysilizium, Aluminium oder Polymere. Geeignete Materialien mit hoher akustischer Impedanz sind beispielsweise Gold (Au), Molybdän (Mo), Wolfram (W) oder Platin (Pt).

In einer weiteren bevorzugten Variante des erfindungsgemäßen Verfahrens werden die erste und zweite piezoelektrische Schicht in unterschiedlichen Schichtdicken abgeschieden. Dies ermöglicht es Bauelemente zu erzeugen, die als Impedanz-Transformatoren dienen können.

In einer weiteren besonders bevorzugten Variante des erfindungsgemäßen Verfahrens werden die untere Elektrode, die erste piezoelektrische Schicht, die mittlere Elektrode, die zweite piezoelektrische Schicht und die obere Elektrode so abgeschieden, dass der aus ihnen gebildete Schichtstapel eine Schichtdicke aufweist, die etwa der halben Wellenlänge der mechanischen Schwingung der Stacked-Crystal-Filter entspricht. Dadurch können Stacked-Crystal-Filter erzeugt werden, die in der akustischen Grundmode betrieben werden können und so eine minimale Resonatorfläche bei gegebenem Impedanzniveau erreichen.

Die Erfindung umfasst weiterhin ein piezoelektrisches Bauelement umfassend zumindest zwei Stacked-Crystal-Filter auf einem Substrat, wobei jeder Stacked-Crystal-Filter wenigstens eine untere Elektrode, eine über der unteren Elektrode angeordnete erste piezoelektrische Schicht, eine über der ersten piezoelektrischen Schicht angeordnete mittlere Elektrode, eine über der mittleren Elektrode angeordnete zweite piezoelektrische Schicht und eine über der zweiten piezoelektrischen Schicht angeordnete obere Elektrode umfasst. Das erfindungsgemäße piezoelektrische Bauelement ist dadurch gekennzeichnet, dass zumindest zwei der jeweiligen unteren und der jeweiligen mittleren Elektroden der Stacked-Crystal-Filter direkt miteinander verbunden sind.

Das erfindungsgemäße piezoelektrische Bauelement weist einen besonders einfachen Aufbau auf, der mit einer geringen Anzahl an Prozessschritten und somit besonders kostengünstig hergestellt werden kann. Das erfindungsgemäße piezoelektrische Bauelement besitzt darüber hinaus den Vorteil, dass Anwendungen, bei denen es auf eine hohe Sperrbanddämpfung ankommt, mit einer relativ geringen Anzahl an Filterstufen realisiert werden können. Dabei kann durch den Einsatz von zumindest zwei Stacked-Crystal-Filter eine ausgezeichnete Fernabselektion auch für "single-ended" Signale erzielt werden.

In einer besonders bevorzugten Ausführungsformen der vorliegenden Erfindung sind die unteren Elektroden erdfrei, wobei es besonders bevorzugt ist, dass das elektrische Potential der unteren Elektroden nicht festgelegt ist.

Insbesondere ist es bevorzugt, dass die unteren Elektroden von zumindest zwei direkt miteinander verbundenen Stacked-Crystal-Filtern und ihre jeweilige direkte Verbindung aus einer Schicht gebildet sind. Weiterhin ist es besonders bevorzugt, auch die mittleren Elektroden und ihre jeweilige direkte Verbindung aus einer Schicht gebildet sind. Diese Struktur kann auf besonders einfache Weise hergestellt werden.

In einer weiteren besonders bevorzugten Ausführungsform des erfindungsgemäßen piezoelektrischen Bauelements sind die oberen Elektroden der jeweiligen Stacked-Crystal-Filter als Signaleingang oder Signalausgang geschaltet.

Besonders bevorzugt ist es, dass oberhalb der oberen Elektroden wenigstens ein oberer akustischer Spiegel angeordnet ist, wobei es insbesondere bevorzugt ist, dass der obere akustische Spiegel aus zumindest einem elektrisch leitfähigen Material gebildet ist. Vorzugsweise ist der obere akustische Spiegel mit den oberen Elektroden direkt leitend verbunden. Für den oberen akustischen Spiegel kommen als geeignete Materialien und Strukturen die bereits im Zusammenhang mit dem erfindungsgemäßen Verfahren beschriebenen Materialien und Strukturen in Frage. Dadurch wird in dem erfindungsgemäßen piezoelektrischen Bauelement eine besonders einfache Kontaktierung der oberen Elektroden über den oberen akustischen Spiegel ermöglicht. Wie bereits für das erfindungsgemäße Verfahren beschrieben, erleichtert dies das "packaging" des Bauelements.

In einer weiteren besonders bevorzugten Ausführungsform der Erfindung umfasst das piezoelektrische Bauelement wenigstens einen unteren akustischen Spiegel, um die Stacked-Crystal-Filter vom Substrat akustisch zu isolieren. Geeignete Spiegelmaterialien und -strukturen wurden bereits im Zusammenhang mit dem erfindungsgemäßen Verfahren erläutert.

Weiterhin ist es besonders bevorzugt, dass das erfindungsgemäße piezoelektrische Bauelement zumindest ein Kontaktloch umfasst, das sich durch die obere Elektrode, bzw. durch die dritte elektrisch leitfähige Schicht aus der die obere Elektrode erzeugt wird, und durch die obere piezoelektrische Schicht erstreckt und über das die mittleren Elektroden mittels zumindest eines elektrisch leitfähigen Materials mit einem vorgegebenen Potential verbunden werden können. Besonders bevorzugt ist hierbei, dass zur Verbindung der mittleren Elektroden mit dem vorgegebenen Potential das gleiche elektrisch leitfähige Material verwendet wird wie zur Ausbildung des oberen akustischen Spiegels. Dieser Aufbau des Bauelements kann in besonders einfacher Weise mit einer minimalen Anzahl von Abscheidungs- und Strukturierungsschritten erfolgen, da hier der obere Spiegel und die Kontaktierung der mittleren Elektrode aus denselben Schichten erzeugt wird.

Wie bereits im Zusammenhang mit dem erfindungsgemäßen Verfahren und aus den dort erläuterten Gründen ist es für die piezoelektrischen Bauelemente der vorliegenden Erfindung besonders bevorzugt, dass in zumindest einem Stacked-Crystal-Filter des Bauelements die Schichtdicke des Schichtstapels aus unterer Elektrode, erster piezoelektrischer Schicht, mittlerer Elektrode, zweiter piezoelektrischer Schicht und oberer Elektrode etwa der halben Wellenlänge der mechanischen Schwingung des Stacked-Crystal-Filter entspricht. Vorzugsweise ist in allen Stacked-Crystal-Filtern des Bauelements die Schichtdicke dieses Schichtstapels im wesentlichen gleich groß.

In weiteren bevorzugten Ausführungsformen der vorliegenden Erfindung umfassen die piezoelektrischen Bauelemente zumindest einen zweistufigen single-ended Schmalbandfilter, zumindest einen Impedanz-Transformator, zumindest einen Leistungsteiler und/oder zumindest einen balanced-Filter.

Wenn das erfindungsgemäße piezoelektrische Bauelement einen Impedanz-Transformator umfasst, ist es besonders bevorzugt dass in dem ersten und zweiten Stacked-Crystal-Filter die erste piezoelektrische Schicht dünner ist als die zweite piezoelektrische Schicht. Besonders bevorzugt ist dabei, dass die unteren und die oberen Elektroden der SCF unterschiedliche Flächenform und/oder Flächeninhalt aufweisen. Dadurch wird eine besonders reflexionsarme Impedanztransformation zwischen Filtereingang und -ausgang möglich.

Die Erfindung wird nachfolgend anhand der Figuren 1 bis 7 näher dargestellt. Es zeigen:
- Fig. 1A bis 1E:: die schematische Darstellung einer bevorzugten Ausführungsform des erfindungsgemäßen Verfahrens;
- Fig. 2: die schematische Darstellung eines erfindungsgemäßen piezoelektrischen Bauelements umfassend einen zweistufigen single-ended Schmalbandfilter;
- Fig. 3: die schematische Darstellung eines erfindungsgemäßen piezoelektrischen Bauelements umfassend zwei in Serie geschaltete zweistufige single-ended Schmalbandfilter;
- Fig. 4: die schematische Darstellung eines erfindungsgemäßen piezoelektrischen Bauelements umfassend einen Impedanz-Transformator;
- Fig. 5: die schematische Darstellung eines erfindungsgemäßen piezoelektrischen Bauelements umfassend einen Leistungsteiler;
- Fig. 6: die schematische Darstellung eines erfindungsgemäßen piezoelektrischen Bauelements umfassend einen balanced-Filter mit "floating"-Mittelelektrode; und
- Fig. 7: die schematische Darstellung eines erfindungsgemäßen piezoelektrischen Bauelements umfassend einen balanced-Filter mit geerdeter Mittelelektrode.

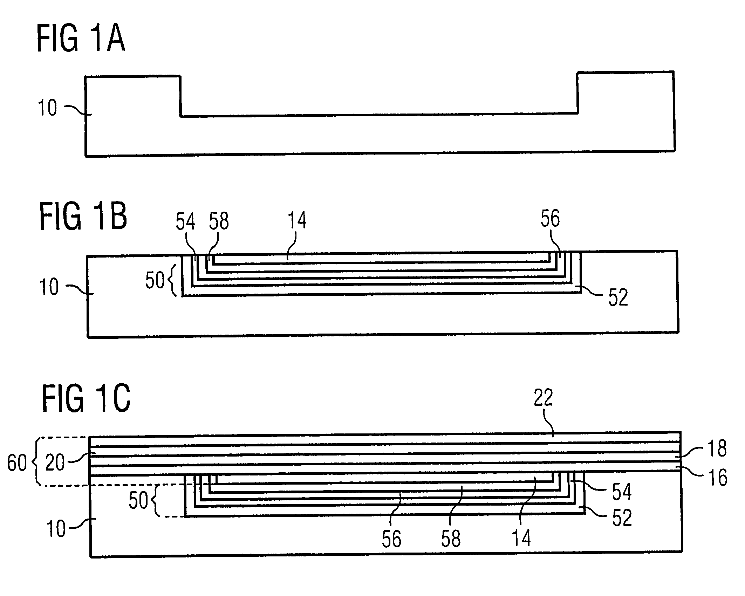

Fig. 1A bis 1E zeigen eine schematische Darstellung einer bevorzugten Ausführungsform des erfindungsgemäßen Verfahrens. In Fig. 1A ist ein Substrat 10 dargestellt, in dem mit herkömmlichen Strukturierungstechniken, z.B. Lithographie und Ätzung, ein Graben erzeugt wurde. In diesem Graben wird ein Schichtstapel abgeschieden, der die Schichten 52, 54, 56, 58 zur Erzeugung eines unteren akustischen Spiegels 50 und eine erste elektrisch leitfähige Schicht enthält. Aus der ersten elektrisch leitfähigen Schicht wird die untere Elektrode 14 erzeugt.

Nach der Abscheidung dieses Schichtstapels werden der untere akustische Spiegel 50 und die untere Elektrode 14 strukturiert. Dies kann durch ein CMP-Verfahren geschehen, wie es beispielsweise in der deutschen Patentanmeldung DE 199 47 081 beschrieben ist.

Fig. 1B zeigt das Substrat 10 mit dem strukturierten unteren akustischen Spiegel 50 und der strukturierten unteren Elektrode 14. Auf das Substrat mit Spiegel 50 und unterer Elektrode 14 werden anschließend nacheinander die erste piezoelektrische Schicht 16, die zweite elektrisch leitfähige Schicht 18, die zweite piezoelektrische Schicht 20 und die dritte elektrisch leitfähige Schicht 22 abgeschieden. Dies ist in Fig. 1C dargestellt. Anschließend kann die obere elektrisch leitfähige Schicht 22 beispielsweise durch Lithographie und Ätzung strukturiert werden. Durch die Strukturierung lediglich dieser einen Schicht 22 können so auf einfache Weise die beiden Stacked-Crystal-Filter 30, 32 mit der beschriebenen Schichtfolge erzeugt werden.

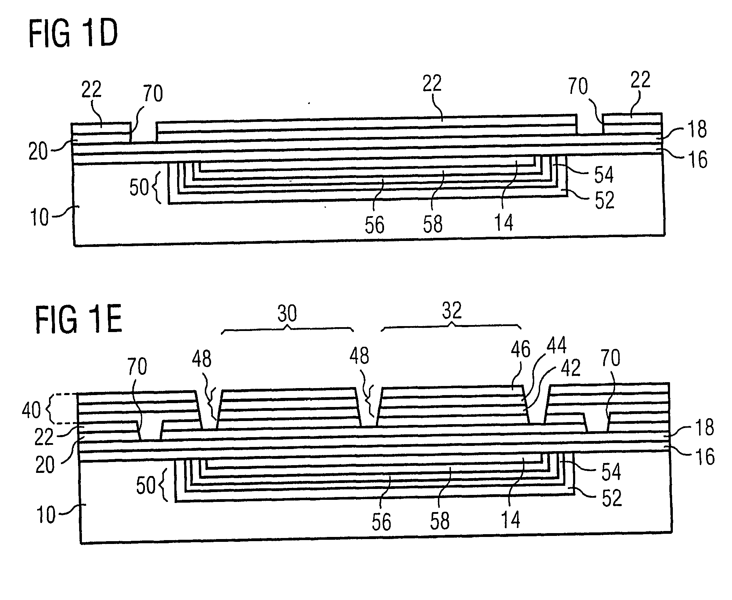

In der bevorzugten, in den Fig. 1A bis 1E dargestellten Ausführungsform des erfindungsgemäßen Verfahrens werden jedoch zuerst in dem in Fig. 1D dargestellten Strukturierungsschritt Öffnungen in der dritten elektrisch leitfähigen Schicht 22 und der zweiten piezoelektrischen Schicht 20 erzeugt. Diese Öffnungen können als Kontaktlöcher dienen, über welche die mittlere Elektrode, die aus der zweiten elektrisch leitfähigen Schicht 18 gebildet wird, mit einem vorgegebenen Potential, vorzugsweise mit der Masse, verbunden werden kann.

Gleichzeitig ist es beispielsweise möglich, mit dieser Ätzung auf zumindest einem ausgesuchten Testbereich auf dem Substrat zumindest einen Stacked-Crystal-Filter zu erzeugen. An dieser Teststruktur kann dann in einem Zwischenschritt die Resonanzfrequenz des Test-SCF gemessen werden. Selbstverständlich können auch mehrere Test-SCF auf verschiedenen Positionen des Substrats erzeugt werden. Anhand der gemessenen Resonanzfrequenz kann entschieden werde, ob eine Nachkorrektur der Schichtdicke der dritten elektrisch leitfähigen Schicht (22) erforderlich ist, um Stacked-Crystal-Filter zu erhalten, welche die gewünschte Resonanzfrequenz aufweisen. Die Schichtdicke der dritten elektrisch leitfähigen Schicht 22 kann gegebenenfalls durch lokales Abätzen korrigiert werden. Dieses lokale Abätzen kann beispielsweise durch lokales Ionenstrahlätzen erfolgen. Denkbar ist allerdings auch, dass die Schichtdicke der dritten elektrisch leitfähigen Schicht 22 durch weiteres Abscheiden von Material erhöht wird.

Anschließend wird, wie in Fig. 1E dargestellt, in weiteren Abscheidungsschritten ein Schichtstapel 40 aus verschiedenen elektrisch leitfähigen Metallen 42, 44, 46 abgeschieden. Die Schichtfolge ist dabei so gewählt, dass die Metalle alternierend eine hohe oder niedrige Impedanz aufweisen. Dadurch sind diese Metallschichten 42, 44, 46 zur Erzeugung eines oberen akustischen Spiegels 48 geeignet, der in einem anschließenden Strukturierungsschritt erzeugt wird (Fig. 1E). Zusätzlich kann mittels der Metallschichten 42, 44 und 46 sowohl eine leitende Verbindung zwischen der aus der zweiten leitfähigen Schicht 18 gebildeten Mittelelektrode und einem vorgegebenen Potential, z.B. Masse, als auch eine Verbindung zwischen den aus der dritten leitfähigen Schicht 22 gebildeten oberen Elektroden und dem Signaleingang bzw. Signalausgang hergestellt werden.

In dem in Fig. 1E dargestellten Strukturierungsschritt werden neben dem oberen akustischen Spiegel auch die Stacked-Crystal-Filter 30 und 32 durch eine oder mehrere entsprechende Ätzungen der Metallschichten 42, 44, und 46 sowie der dritten elektrisch leitfähigen Schicht 22 erzeugt.

Durch das vorhergehend beschriebene Verfahren kann auf besonders einfache Weise sowohl die Strukturierung als auch Kontaktierung der Stacked-Crystal-Filter in dem Substrat erreicht werden.

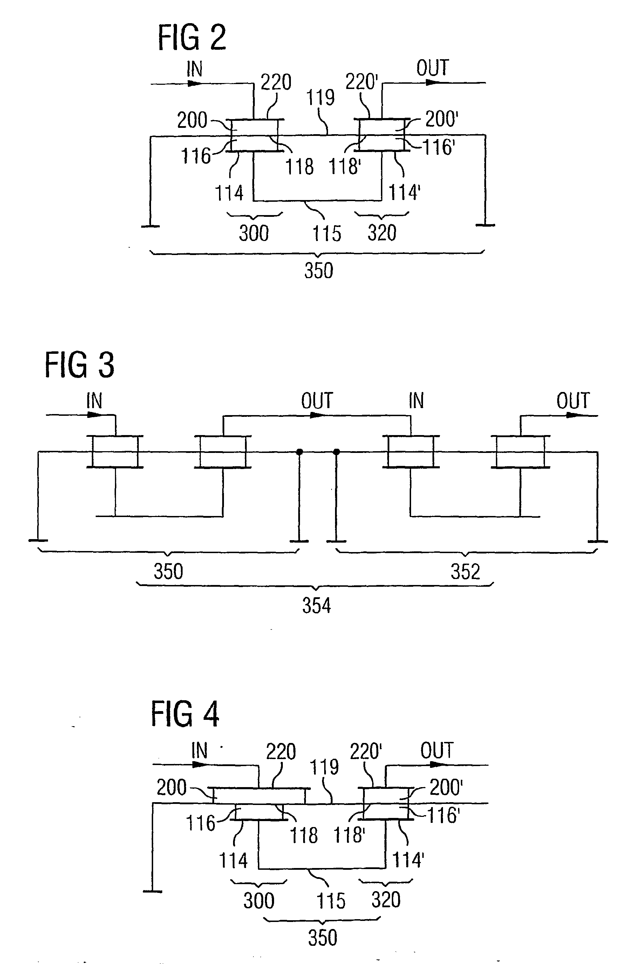

In den Figuren 2 bis 7 sind verschiedene bevorzugte Ausführungsformen der erfindungsgemäßen piezoelektrischen Bauelemente schematisch dargestellt. In all diesen Figuren sind gleiche Bauteile mit gleichen Bezugszahlen benannt. In einigen Figuren sind diese Bauteile zur besseren Unterscheidbarkeit in den verschiedenen Komponenten der Bauelemente mit den Indizes (') oder (") versehen. In einigen Figuren sind nur die wesentlichen übergeordneten Komponenten mit Bezugszeichen versehen, um die Übersichtlichkeit zu wahren. In diesen Figuren können aber den einzelnen Bauteilen der Bauelemente analoge Bezugszeichen zugeordnet werden, was sich aus dem Vergleich mit vorherigen Figuren unmittelbar ergibt. Die im folgenden beschriebenen Bauelemente lassen sich besonders einfach nach dem erfindungsgemäßen Verfahren herstellen.

In Fig. 2 ist eine bevorzugte Ausführungsform eines erfindungsgemäßen piezoelektrischen Bauelements dargestellt, das einen zweistufigen single-ended Schmalbandfilter 350 umfasst.

Dieser ist aus zwei Stacked-Crystal-Filtern 300, 320 aufgebaut, die über ihre unteren Elektroden 114, 114' mittels einer gemeinsamen Verbindung 115 direkt miteinander verbunden sind. Jeder SCF 300, 320 umfaßt eine erste piezoelektrische Schicht 116, 116', eine mittlere Elektrode 118, 118', eine zweite piezoelektrische Schicht 200, 200' und eine obere Elektrode 220, 220'. Die mittleren Elektroden sind über eine gemeinsame Verbindung 119 direkt miteinander verbunden und sind geerdet. Die obere Elektrode 220 des einen SCF 300 ist mit dem Signaleingang verbunden, die obere Elektrode 220' des anderen SCF 320 ist mit dem Signalausgang verbunden.

Um die Filterselektivität weiter zu erhöhen, sind in dem in Figur. 3 dargestellten Filter zwei der in Figur 2 gezeigten "single-ended Schmalbandfilter" 350, 352 zu einem vierstufigen Filter zusammengeschaltet.

Das in Figur 4 dargestellte piezoelektrisches Bauelement wirkt wie ein Impedanz-Transformator 360. In der dort gezeigten Ausführungsform wird die Impedanztransformation dadurch erreicht, dass die jeweils ersten piezoelektrischen Schichten 116, 116' in den SCF 300, 320 eine geringere Schichtdicke aufweisen, als die jeweiligen zweiten piezoelektrischen Schichten. Zusätzlich sind in dem einen SCF 300 des Impedanz-Transformators 360 die Flächen der unteren Elektrode 114 und der oberen Elektrode 220 unterschiedlich groß gestaltet, wodurch eine reflexionsarme Impedanztransformation zwischen Filtereingang und -ausgang erreicht wird.

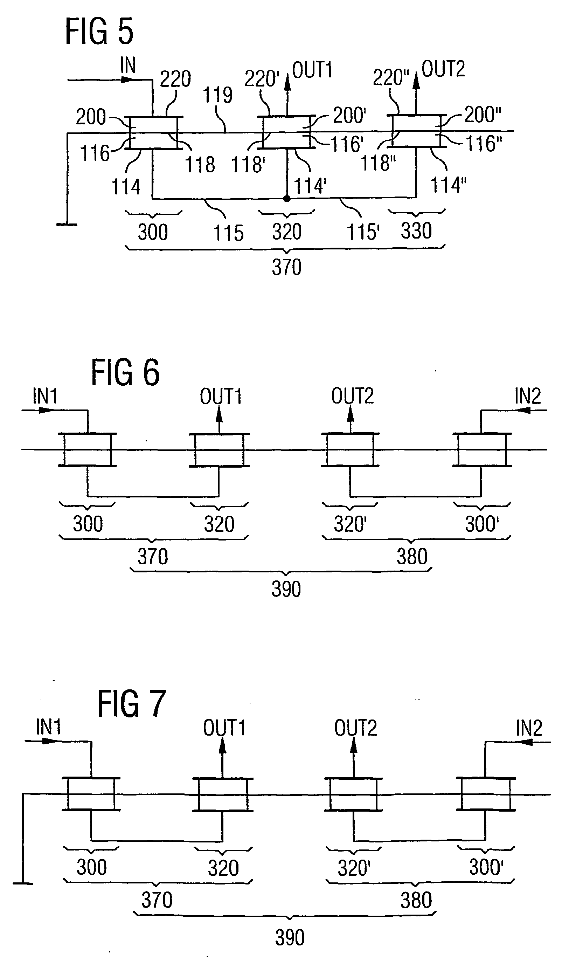

In Fig. 5 ist ein piezoelektrisches Bauelement dargestellt, das als Leistungsteiler 370 dient. Die drei SCF 300, 320, 330 sind über ihre unteren Elektroden 114, 114', 114'' und ihre geerdeten mittleren Elektroden 118, 118', 118" direkt miteinander verbunden. Die obere Elektrode 220 des einen SCF 300 ist mit dem Signaleingang verbunden, die oberen Elektroden der jeweils anderen SCF 320, 330 sind mit Signalausgängen verbunden.

Die in Fig. 6 und 7 dargestellten Filter sind balanced-Filter 390. Sie umfassen jeweils vier SCF 300, 320; 300' 320', die alle über ihre mittleren Elektroden 118 direkt miteinander verbunden sind. Jeweils zwei der SCF sind über ihre jeweiligen unteren Elektroden direkt miteinander verbunden, wodurch zwei SCF-Paare 370, 380 gebildet werden. Innerhalb eines SCF-Paares 370, 380 ist die obere Elektrode eines SCF 300, 300' mit dem Signaleingang, die des anderen SCF 320, 320' mit dem Signalausgang verbunden.

In dem in Figur 6 dargestellten Filtert sind die mittleren Elektroden erdfrei, d.h. "floating", wohingegen die mittleren Elektroden in dem in Fig. 7 dargestellten Filter mit der Masse verbunden sind.

## Patentansprüche

1. Verfahren zur Herstellung eines piezoelektrischen Bauelements enthaltend zumindest zwei Stacked-Crystal-Filter (30, 32), umfassend die folgenden Schritte:
a) ein Substrat (10) wird bereitgestellt;
b) auf dem Substrat (10) wird aus einer auf dem Substrat (10) aufgebrachten ersten elektrisch leitfähigen Schicht zumindest eine untere Elektrode (14) erzeugt;
c) auf dem Substrat (10) wird zumindest im Bereich der unteren Elektrode (14) ein Schichtstapel aufgebracht, der, beginnend mit der untersten Schicht, eine erste piezoelektrische Schicht (16), eine zweite elektrisch leitfähige Schicht (18), eine zweite piezoelektrische Schicht (20) und eine dritte elektrisch leitfähige Schicht (22)umfasst;
d) lediglich die dritte elektrisch leitfähige Schicht (22) und ggf. die zweite piezoelektrische Schicht (20) werden strukturiert, so dass zumindest zwei Stacked-Crystal-Filter (30, 32) erzeugt werden;
e) die dritte elektrisch leitfähige Schicht (22) wird kontaktiert.

2. Verfahren nach Anspruch 1,
**dadurch gekennzeichnet, dass**
zumindest eine Öffnung (70) in der zweiten piezoelektrischen Schicht (20) erzeugt wird und zusätzlich die zweite elektrisch leitfähige Schicht (18) kontaktiert wird.

3. Verfahren nach einem der Ansprüche 1 oder 2,
**dadurch gekennzeichnet, dass** vor Schritt e.) die Resonanzfrequenz zumindest eines der erzeugten Stacked-Crystal-Filter (30, 32) gemessen und gegebenenfalls in einem weiteren Schritt durch lokales Abätzen die Schichtdicke der dritten elektrisch leitfähigen Schicht (22) korrigiert wird.

4. Verfahren nach einem der Ansprüche 1 bis 3,
**dadurch gekennzeichnet, dass** vor Schritt d.) und/oder e.) zumindest ein oberer akustischer Spiegel (48) erzeugt wird, vorzugsweise aus einem auf der dritten elektrisch leitfähigen Schicht (22) aufgebrachten Schichtstapel (40), wobei der Schichtstapel (40) zumindest eine Schicht aus einem elektrisch leitfähigen Metall aufweist und vorzugsweise alle Schichten des Schichtstapels (40) elektrisch leitfähig sind.

5. Verfahren nach Anspruch 4,
**dadurch gekennzeichnet, dass** der obere akustische Spiegel (48) eine Schichtfolge von elektrisch leitfähigen Metallen (42, 44, 46) umfasst, die abwechselnd eine hohe und niedrige akustischer Impedanz aufweisen.

6. Verfahren nach einem der Ansprüche 1 bis 5,
**dadurch gekennzeichnet, dass** die erste (16) und zweite piezoelektrische Schicht (20) unterschiedliche Schichtdicken aufweisen.

7. Verfahren nach einem der Ansprüche 1 bis 6,
**dadurch gekennzeichnet, dass** vor Schritt b.) in dem Substrat (10) ein unterer akustischer Spiegel (50) erzeugt wird.

8. Verfahren nach Anspruch 7,
**dadurch gekennzeichnet, dass** der untere akustische Spiegel (50) eine Schichtfolge (52, 54, 56, 58) aus Materialien mit alternierend hoher und niedriger akustischer Impedanz umfaßt.

9. Verfahren nach einem der Ansprüche 1 bis 8,
**dadurch gekennzeichnet, dass** die untere Elektrode (14), die erste piezoelektrische Schicht (16), die mittlere Elektrode (18), die zweite piezoelektrische Schicht (20) und die oberer Elektrode (22) so abgeschieden werden, dass der aus diesen Schichten gebildete Schichtstapel (60) eine Schichtdicke aufweist, die etwa der halben Wellenlänge der mechanischen Schwingung der Stacked-Crystal-Filter (30, 32) entspricht.

10. Piezoelektrisches Bauelement (350, 354, 360, 370, 390) umfassend zumindest zwei Stacked-Crystal-Filter (300,320) auf einem Substrat, wobei jeder Stacked-Crystal-Filter (300, 320) wenigstens eine untere Elektrode (114, 114'), eine über der unteren Elektrode angeordnete erste piezoelektrische Schicht (116, 116'), eine über der ersten piezoelektrischen Schicht angeordnete mittlere Elektrode (118, 118'), eine über der mittleren Elektrode angeordnete zweite piezoelektrische Schicht (200, 200') und eine über der zweiten piezoelektrischen Schicht angeordnete obere Elektrode (220, 220') umfasst,
wobei zumindest zwei der jeweiligen unteren Elektroden (114, 114') direkt miteinander verbunden sind und zumindest zwei der jeweiligen mittleren Elektroden (118, 118') der Stacked-Crystal-Filter (300, 320) direkt miteinander verbunden sind, und wobei
die direkt miteinander verbundenen unteren Elektroden (114, 114') und ihre jeweilige direkte Verbindung (115) aus einer Schicht gebildet sind und die direkt miteinander verbundenen mittleren Elektroden (118, 118') und ihre jeweilige direkte Verbindung (119) aus einer Schicht gebildet sind.

11. Piezoelektrisches Bauelement nach Anspruch 10,
**dadurch gekennzeichnet, dass** die unteren Elektroden (114, 114') erdfrei sind.

12. Piezoelektrisches Bauelement nach Anspruch 10 oder 11,
**dadurch gekennzeichnet, dass** das elektrische Potential der unteren Elektroden (114, 114') nicht festgelegt ist.

13. Piezoelektrisches Bauelement nach einem der Ansprüche 10 bis 12,
**dadurch gekennzeichnet, dass** die oberen Elektroden (220, 220') der Stacked-Crystal-Filter (300, 320), die direkt über ihre unteren Elektroden (114, 114') miteinander verbunden sind, als Signaleingang oder Signalausgang verwendet werden.

14. Piezoelektrisches Bauelement nach einem der Ansprüche 10 bis 13,
**dadurch gekennzeichnet, dass** das piezoelektrische Bauelement wenigstens einen unteren akustischen Spiegel (50) umfasst.

15. Piezoelektrisches Bauelement nach einem der Ansprüche 10 bis 14,
**dadurch gekennzeichnet, dass** oberhalb der oberen Elektroden (114, 114') wenigstens ein oberer akustischer Spiegel (48) angeordnet ist.

16. Piezoelektrisches Bauelement nach Anspruch 15,
**dadurch gekennzeichnet, dass** der obere akustische Spiegel (48) aus zumindest einem elektrisch leitfähigen Material gebildet ist.

17. Piezoelektrisches Bauelement nach Anspruch 16,
**dadurch gekennzeichnet, dass** der obere akustische Spiegel (48) mit den oberen Elektroden (220, 220') direkt leitend verbunden ist.

18. Piezoelektrisches Bauelement nach einem der Ansprüche 10 bis 17,
**dadurch gekennzeichnet, dass** das piezoelektrische Bauelement zumindest ein Kontaktloch (70) umfasst, das sich durch die obere Elektrode (220, 220') und die obere piezoelektrische Schicht (200, 200') erstreckt und über das die mittlere Elektrode (118, 118') mittels zumindest eines elektrisch leitfähigen Materials mit einem vorgegebenen Potential verbunden werden kann.

19. Piezoelektrisches Bauelement nach Anspruch 18,
**dadurch gekennzeichnet, dass** zur Verbindung der mittleren Elektrode (118, 118') mit dem vorbestimmten Potential das gleiche elektrisch leitfähige Material verwendet wird wie zur Ausbildung des oberen akustischen Spiegels (48).

20. Piezoelektrisches Bauelement nach einem der Ansprüche 10 bis 19,
**dadurch gekennzeichnet, dass** das piezoelektrische Bauelement zumindest einen zweistufigen single-ended Schmalbandfilter (350) umfaßt,
umfassend zumindest einen ersten und zweiten besagter Stacked-Crystal-Filter (300, 320),
wobei die obere Elektrode (220) des ersten Stacked-Crystal-Filter (300) als Signaleingang geschaltet ist, und die obere Elektrode (220') des zweiten Stacked-Crystal-Filter (320) als Signalausgang geschaltet ist, wobei die mittleren Elektroden (118, 118') geerdet sind.

21. piezoelektrisches Bauelement nach Anspruch 20,
**dadurch gekennzeichnet, dass** das piezoelektrische Bauelement wenigstens zwei in Serie geschaltete zweistufige single-ended Schmalbandfilter (350, 352) umfasst.

22. Piezoelektrisches Bauelement nach einem der Ansprüche 10 bis 21,
**dadurch gekennzeichnet, dass** das piezoelektrische Bauelement zumindest einen Impedanz-Transformator (360) umfasst,
umfassend zumindest einen und einen weiteren besagter Stacked-Crystal-Filter (300, 320), die wie in den Ansprüchen 10 bis 19 beschrieben aufgebaut und verbunden sind,
wobei die obere Elektrode (220) des einen Stacked-Crystal-Filter (300) als Signaleingang geschaltet ist, und die obere Elektrode (220') des weiteren Stacked-Crystal-Filter (320) als Signalausgang geschaltet ist, wobei die mittleren Elektroden (118, 118') der Stacked-Crystal-Filter (300, 320) geerdet sind, und wobei die Impedanz des einen Stacked-Crystal-Filters (300) kleiner ist als die Impedanz des weiteren Stacked-Crystal-Filters (320).

23. Piezoelektrisches Bauelement nach Anspruch 22, **dadurch gekennzichnet,** dass
in dem einen und dem weiteren Stacked-Crystal-Filter (300, 320) die erste piezoelektrische Schicht (116, 116') dünner ist als die zweite piezoelektrische (200, 200') Schicht.

24. Piezoelektrisches Bauelement nach Anspruch 22 oder 23,
**dadurch gekennzeichnet, dass** die unteren (114, 114') und die oberen Elektroden (116, 116') unterschiedliche Flächenform und/oder Flächeninhalt aufweisen.

25. Piezoelektrisches Bauelement nach einem der Ansprüche 10 bis 19,
**dadurch gekennzeichnet, dass** das piezoelektrische Bauelement zumindest einen Leistungsteiler (370) umfasst,
umfassend wenigstens einen ersten, zweiten und dritten besagter stacked-Crystal-Filter (300, 320, 330), die wie in den Ansprüchen 10 bis 19 beschrieben aufgebaut und verbunden sind,
wobei die obere Elektrode (220) des ersten Stacked-Crystal-Filters (330) als Signaleingang und die oberen Elektroden (220', 220") des zweiten und dritten Stacked-Crystal-Filters (320, 330) jeweils als Signalausgang geschaltet sind, die unteren Elektroden (114, 114', 114'') und die mittleren Elektroden (118, 118', 118") des ersten, zweiten und dritten Stacked-Crystal-Filters (300, 320, 330) direkt miteinander verbunden sind und die mittleren Elektroden (118, 118', 118") geerdet sind.

26. Piezoelektrisches Bauelement nach einem der Ansprüche 10 bis 19,
**dadurch gekennzeichnet, dass** das piezoelektrische Bauelement zumindest einen balanced-Filter (390) umfasst, umfassend vier besagter Stacked-Crystal-Filter (300, 300', 320, 320'), deren mittlere Elektroden (118) direkt miteinander verbunden sind und die unteren Elektroden (114) von je zwei dieser letztgenannten Stacked-Crystal-Filtern (300, 320; 300', 320') wie in den Ansprüchen 10 bis 19 beschrieben aufgebaut und direkt miteinander verbunden sind, wodurch zwei Stacked-Crystal-Filter-Paare (370, 380) gebildet werden und wobei in jedem Stacked-Crystal-Filter-Paar (370, 380) eine obere Elektrode (220) als Signaleingang und eine obere Elektrode (220') als Signalausgang geschaltet ist.

27. Piezoelektrisches Bauelement nach Anspruch 26,
**dadurch gekennzeichnet, dass** die mittleren Elektroden (118) geerdet sind.

28. Piezoelektrisches Bauelement nach einem der Ansprüche 10 bis 27,
**dadurch gekennzeichnet, dass** in zumindest einem der Stacked-Crystal-Filter (300, 320) des Bauelements die erste Elektrode (114), die erste piezoelektrische Schicht (116), die mittlere Elektrode (118), die zweite piezoelektrischer Schicht (200) und die obere Elektrode (220) einen Schichtstapel (60) bilden, dessen Schichtdicke etwa der halben Wellenlänge der mechanischen Schwingung des Stacked-Crystal-Filter (300, 320) entspricht.

## Claims

1. A method for producing a piezoelectric component containing at least two stacked crystal filters (30, 32), comprising the following steps:
a) a substrate (10) is provided;
b) on the substrate (10), at least one bottom electrode (14) is produced from a first electrically conductive layer applied on the substrate (10);
c) on the substrate (10), a layer stack is applied at least in the region of the bottom electrode (14), which layer stack comprises, beginning with the bottommost layer, a first piezoelectric layer (16), a second electrically conductive layer (18), a second piezoelectric layer (20) and a third electrically conductive layer (22);
d) only the third electrically conductive layer (22) and, if appropriate, the second piezoelectric layer (20) are patterned, so that at least two stacked crystal filters (30, 32) are produced;
e) the third electrically conductive layer (22) is contact-connected.

2. The method as claimed in claim 1,
**characterized in that**
at least one opening (70) is produced in the second piezoelectric layer (20) and, in addition, the second electrically conductive layer (18) is contact-connected.

3. The method as claimed in either of claims 1 and 2,
**characterized in that**,
before step e.), the resonant frequency of at least one of the stacked crystal filters (30, 32) produced is measured and, if appropriate, in a further step, the layer thickness of the third electrically conductive layer (22) is corrected by local etching-away.

4. The method as claimed in one of claims 1 to 3,
**characterized in that**,
before step d.) and/or e.), at least one upper acoustic mirror (48) is produced, preferably from a layer stack (40) applied on the third electrically conductive layer (22), the layer stack (40) having at least one layer made of an electrically conductive metal and preferably all the layers of the layer stack (40) being electrically conductive.

5. The method as claimed in claim 4,
**characterized in that**
the upper acoustic mirror (48) comprises a layer sequence of electrically conductive metals (42, 44, 46) which alternately have a high and low acoustic impedance.

6. The method as claimed in one of claims 1 to 5,
**characterized in that**
the first (16) and second piezoelectric layer (20) have different layer thicknesses.

7. The method as claimed in one of claims 1 to 6,
**characterized in that**,
before step b.), a lower acoustic mirror (50) is produced in the substrate (10).

8. The method as claimed in claim 7,
**characterized in that**
the lower acoustic mirror (50) comprises a lower sequence (52, 54, 56, 58) made of materials having alternately a high and a low acoustic impedance.

9. The method as claimed in one of claims 1 to 8,
**characterized in that** the bottom electrode (14), the first piezoelectric layer (16), the central electrode (18), the second piezoelectric layer (20) and the top electrode (22) are deposited in such a way that the layer stack (60) formed from these layers has a layer thickness which corresponds approximately to half the wavelength of the mechanical oscillation of the stacked crystal filters (30, 32).

10. A piezoelectric component (350, 354, 360, 370, 390)
comprising at least two stacked crystal filters (300, 320) on a substrate, each stacked crystal filter (300, 320) comprising at least one bottom electrode (114, 114'), a first piezoelectric layer (116, 116') arranged above the bottom electrode, a central electrode (118, 118') arranged above the first piezoelectric layer, a second piezoelectric layer (200, 200') arranged above the central electrode, and a top electrode (220, 220') arranged above the second piezoelectric layer,
wherein at least two of the respective bottom and of the respective central electrodes (114, 114', 118, 118') of the stacked crystal filters (300, 320) are directly connected to one another, and
wherein the bottom electrodes (114, 114'), which are directly connected to one another, and their respective direct connection (115) are formed from one layer, and the central electrodes (118, 118'), which are directly connected to one another, and their respective direct connection (119) are formed from one layer.

11. The piezoelectric component as claimed in claim 10,
**characterized in that**
the bottom electrodes (114, 114') are ungrounded.

12. The piezoelectric component as claimed in claim 10 or 11,
**characterized in that**
the electrical potential of the bottom electrodes (114, 114') is not defined.

13. The piezoelectric component as claimed in one of claims 10 to 12
**characterized in that**
the top electrodes (220, 220') of the stacked crystal filters (300, 320), which are directly connected to one another via their bottom electrodes (114, 114') are used as signal input or signal output.

14. The piezoelectric component as claimed in one of claims 10 to 13
**characterized in that**
the piezoelectric component comprises at least one lower acoustic mirror (50).

15. The piezoelectric component as claimed in one of claims 10 to 14,
**characterized in that**
at least one upper acoustic mirror (48) is arranged above the top electrodes (114, 114').

16. The piezoelectric component as claimed in claim 15,
**characterized in that**
the upper acoustic mirror (48) is formed from at least one electrically conductive material.

17. The piezoelectric component as claimed in claim 16,
**characterized in that**
the upper acoustic mirror (48) is directly conductively connected to the top electrodes (220, 220').

18. The piezoelectric component as claimed in one of claims 10 to 17,
**characterized in that**
the piezoelectric component comprises at least one contact hole (70), which extends through the top electrode (220, 220') and the upper piezoelectric layer (200, 200') and via which the central electrode (118, 118') can be connected to a predetermined potential by means of at least one electrically conductive material.

19. The piezoelectric component as claimed in claim 18,
**characterized in that**
the same electrically conductive material is used for connecting the central electrode (118, 118') to the predetermined potential as for forming the upper acoustic mirror (48).

20. The piezoelectric component as claimed in one of claims 10 to 19,
**characterized in that**
the piezoelectric component comprises at least one two-stage single-ended narrowband filter (350), comprising a first and a second of said stacked crystal filter (300, 320), the top electrode (220) of the first stacked crystal filter is connected as signal input and the top electrode (220') of the second stacked crystal filter is connected as signal output, wherein the central electrodes (118, 118') are grounded.

21. The piezoelectric component as claimed in claim 20,
**characterized in that**
the piezoelectric component comprises at least two series-connected two-stage single-ended narrowband filters (350, 352) .

22. The piezoelectric component as claimed in one of claims 10 to 21,
**characterized in that**
the piezoelectric component comprises at least one impedance transformer (360),
comprising at least one and a further of said stacked crystal filters (300, 320) designed and connected as described in the claims 10 to 19,
the top electrode (220) of the at least one stacked crystal filter being connected as signal input, and the top electrode (220') of the further stacked crystal filter (320) being connected as signal output, the central electrodes (118, 118') of the stacked crystal filters (300, 320) being grounded, and the impedance of the at least one stacked crystal filter (300) being less than the impedance of the further stacked crystal filter (320).

23. The piezoelectric component as claimed in claim 22,
**characterized in that**,
in the at least one and the further stacked crystal filters (300, 320), the first piezoelectric layer (116, 116') is thinner than the second piezoelectric layer (200, 200').

24. The piezoelectric component as claimed in claim 22 or 23,
**characterized in that**
the bottom (114, 114') and the top electrodes (116, 116') have a different areal form and/or areal content.

25. The piezoelectric component as claimed in one of claims 10 to 19,
**characterized in that**
the piezoelectric component comprises at least one power divider (370), comprising at least a first, second and third of said stacked crystal filter (300, 320, 330) designed and connected as described in the claims 10 to 19,
the top electrode (220) of the first stacked crystal filter (330) being connected as signal input and the top electrodes (220', 220") of the second and third stacked crystal filters (320, 330) in each case being connected as signal output, the bottom electrodes (114, 114', 114") and the central electrodes (118, 118', 118") of the first, second and third stacked crystal filters (300, 320, 330) being directly connected to one another and the central electrodes (118, 118', 118'') being grounded.

26. The piezoelectric component as claimed in one of claims 10 to 19,
**characterized in that**
the piezoelectric component comprises at least one balanced filter (390), comprising four of said stacked crystal filters (300, 300', 320, 320'), the central electrodes (118) of which are directly connected to one another and the bottom electrodes (114) of each two of the last-mentioned stacked crystal filters (300, 320; 300', 320') are designed and directly connected to one another as described in the claims 10 to 19, thereby forming two stacked crystal filter pairs (370, 380), and, in each stacked crystal filter pair (370, 380), one top electrode (220) is connected as signal input and one top electrode (220') is connected as signal output.

27. The piezoelectric component as claimed in claim 26,
**characterized in that**
the central electrodes (118) are grounded.

28. The piezoelectric component as claimed in one of claims 10 to 27,
**characterized in that**,
in at least one of the stacked crystal filters (300, 320) of the component, the first electrode (114), the first piezoelectric layer (116), the central electrode (118), the second piezoelectric layer (200) and the top electrode (220) form a layer stack (60), whose layer thickness corresponds approximately to half the wavelength of the mechanical oscillation of the stacked crystal filter (300, 320).

## Revendications

1. Procédé de production d'un composant piézoélectrique contenant au moins deux stacked-crystal-filters (30, 32) comprenant les stades suivants :
a) on se procure un substrat (10) ;
b) on produit au moins une électrode (14) inférieure sur le substrat (10) à partir d'une première couche conductrice de l'électricité déposée sur le substrat (10) ;
c) on dépose sur le substrat (10) au moins dans la partie de l'électrode (14) inférieure une pile de couches qui, en partant de la couche la plus basse, comprend une première couche (16) piézoélectrique, une deuxième couche (18) conductrice de l'électricité, une deuxième couche (20) piézoélectrique et une troisième couche (22) conductrice de l'électricité ;
d) on structure seulement la troisième couche (22) conductrice de l'électricité et, le cas échéant, la deuxième couche (20) piézoélectrique de manière à produire au moins deux stacked-crystal-filters (30,32) ;
e) on met en contact la troisième couche (22) conductrice de l'électricité.

2. Procédé suivant la revendication 1,
**caractérisé en ce que** l'on produit au moins une ouverture (70) dans la deuxième couche (20) piézoélectrique et on met en contact, en outre, la deuxième couche (18) conductrice de l'électricité.

3. Procédé suivant l'une des revendications 1 ou 2,
**caractérisé en ce qu'**avant le stade e) on mesure la fréquence à la résonance d'au moins l'un des stacked-crystal-filters (30, 32) produits et on corrige, le cas échéant, dans un autre stade par attaque locale l'épaisseur de la troisième couche (22) conductrice de l'électricité.

4. Procédé suivant l'une des revendications 1 à 3,
**caractérisé en ce qu'**avant le stade d) et/ou e) on produit au moins un miroir (48) acoustique supérieur, de préférence à partir d'une pile (40) de couches déposées sur la troisième couche (22) conductrice de l'électricité, la pile (40) de couche ayant au moins une couche en un métal conducteur de l'électricité et, de préférence, toutes les couches de la pile (40) de couches étant conductrices de l'électricité.

5. Procédé suivant la revendication 4,
**caractérisé en ce que** le miroir (48) acoustique supérieur comprend une succession de couches de métaux (42, 44, 46) conducteurs de l'électricité qui ont, en alternance, une impédance acoustique grande et petite.

6. Procédé suivant l'une des revendications 1 à 5,
**caractérisé en ce que** la première (16) et la deuxième (20) couches piézoélectriques ont des épaisseurs différentes.

7. Procédé suivant l'une des revendications 1 à 6,
**caractérisé en ce qu'**avant le stade b) on produit dans le substrat (10) un miroir (50) acoustique inférieur.

8. Procédé suivant la revendication 7,
**caractérisé en ce que** le miroir (50) acoustique inférieur comprend une succession (52, 54, 56, 58) de couches en des matériaux ayant des impédances acoustiques alternées grandes et petites.

9. Procédé suivant l'une des revendications 1 à 8,
**caractérisé en ce que** l'on dépose l'électrode (14) inférieure, la première couche (16) piézoélectrique, l'électrode (18) médiane, la deuxième couche (20) piézoélectrique et l'électrode (22) supérieure de façon à ce que la pile (60) de couches formée à partir de ces couches ait une épaisseur qui corresponde à peu près à la demi-longueur d'onde de l'oscillation mécanique des stacked-crystal-filters (30, 32).

10. Composant (350, 354, 360, 370, 390) piézoélectrique comprenant au moins deux stacked-crystal-filters (300, 320) sur un substrat, chaque stacked-crystal-filter (300, 320) comprenant au moins une électrode (114, 114') inférieure, une première couche (116, 116') piézoélectrique disposée sur l'électrode inférieure, une électrode (118, 118') médiane disposée sur la première couche piézoélectrique, une deuxième couche (200, 200') piézoélectrique disposée sur l'électrode médiane et une électrode (220, 220') supérieure disposée sur la deuxième couche piézoélectrique,
dans lequel au moins deux des électrodes (114, 114') inférieures respectives sont reliées directement entre elles et au moins deux des électrodes (118, 118') médianes respectives des stacked-crystal-filters (300, 320) sont reliées directement entre elles,
et dans lequel
les électrodes (114, 114') inférieures reliées directement entre elles et leur liaison (115) directe respective sont formées d'une couche et les électrode (118, 118') médianes reliées directement entre elles et leur liaison (119) directe respective sont formées d'une couche.

11. Composant piézoélectrique suivant la revendication 10,
**caractérisé en ce que** les électrodes (114, 114') inférieures sont isolées de la terre.

12. Composant piézoélectrique suivant la revendication 10 ou 11,
**caractérisé en ce que** le potentiel électrique des électrodes (114, 114') inférieures n'est pas fixé.

13. Composant piézoélectrique suivant l'une des revendications 10 à 12,
**caractérisé en ce que** les électrodes (220, 220') supérieures des stacked-crystal-filters (300, 320) qui sont reliés directement entre eux par leurs électrodes (114, 114') inférieures sont utilisées comme entrée de signal ou comme sortie de signal.

14. Composant piézoélectrique suivant l'une des revendications 10 à 13,
**caractérisé en ce que** le composant piézoélectrique comprend au moins un miroir (50) acoustique inférieur.

15. Composant piézoélectrique suivant l'une des revendications 10 à 14,
**caractérisé en ce qu'**au moins un miroir (48) acoustique supérieur est disposé au-dessus des électrodes (114, 114') supérieures.

16. Composant piézoélectrique suivant la revendication 15,
**caractérisé en ce que** le miroir (48) acoustique supérieur est formé d'au moins un matériau conducteur de l'électricité.

17. Composant piézoélectrique suivant la revendication 16,
**caractérisé en ce que** le miroir (48) acoustique supérieur est relié directement d'une manière conductrice aux électrodes (220, 220') supérieures.

18. Composant piézoélectrique suivant l'une des revendications 10 à 17,
**caractérisé en ce que** le composant piézoélectrique comprend au moins un trou (70) de contact qui s'étend à travers l'électrode (220, 220') supérieure et la couche (200, 200') piézoélectrique supérieure et peut être relié à un potentiel prescrit au moyen d'au moins un matériau conducteur de l'électricité.

19. Composant piézoélectrique suivant la revendication 18,
**caractérisé en ce que**, pour relier l'électrode (118, 118') médiane au potentiel déterminé à l'avance, il est utilisé le même matériau conducteur de l'électricité que pour former le miroir (48) acoustique supérieur.

20. Composant piézoélectrique suivant l'une des revendications 10 à 19,
**caractérisé en ce que** le composant piézoélectrique comprend au moins un filtre (350) à bande étroite à deux étages single-ended,
comprenant au moins un premier et un deuxième dits stacked-crystal-filters (300, 320),
dans lequel l'électrode (220) supérieure du premier stacked-crystal-filter (300) est montée en entrée de signal et l'électrode (220') supérieure du deuxième stacked-crystal-filter (320) est montée en sortie de signal, les électrodes (118, 118') médianes étant mises à la terre.

21. Composant piézoélectrique suivant la revendication 20,
**caractérisé en ce que** le composant piézoélectrique comprend au moins deux filtres (350, 352) à bande étroite à deux étages single-ended montés en série.

22. Composant piézoélectrique suivant l'une des revendications 10 à 21,
**caractérisé en ce que** le composant piézoélectrique comprend au moins un transformateur (360) d'impédance,
comprenant au moins un et un autre dits stacked-crystal-filters (300, 320) qui sont formés et reliés comme décrit dans les revendications 10 à 19,
l'électrode (220) supérieure de l'un des stacked-crystal-filters (300) étant montée en entrée de signal et l'électrode (220') supérieure de l'autre stacked-crystal-filter (320) étant montée en sortie de signal, les électrodes (118, 118') médianes des stacked-crystal-filters (300, 320) étant mises à la terre et l'impédance de l'un des stacked-crystal-filters (300) étant plus petite que l'impédance de l'autre stacked-crystal-filter (320).

23. Composant piézoélectrique suivant la revendication 22,
**caractérisé en ce que**, dans l'un et dans l'autre des stacked-crystal-filters (300, 320), la première couche (116, 116') piézoélectrique est plus mince que la deuxième couche (200, 220') piézoélectrique.

24. Composant piézoélectrique suivant la revendication 22 ou 23,
**caractérisé en ce que** les électrodes inférieures (114, 114') et supérieures (116, 116') ont des formes de surface et/ou des superficies différentes.

25. Composant piézoélectrique suivant l'une des revendications 10 à 19,
**caractérisé en ce que** le composant piézoélectrique comprend au moins un diviseur (370) de puissance,
comprenant au moins un premier, deuxième et troisième dits stacked-crystal-filters (300, 320, 330) qui sont formés et reliés comme décrit dans les revendications 10 à 19,
l'électrode (220) supérieure du premier stacked-crystal-filter (300) étant montée en entrée de signal et les électrodes (220', 220") supérieures du deuxième et du troisième stacked-crystal-filters (320, 330) étant montées respectivement en sortie de signal, les électrodes (114, 114', 114") inférieures et les électrodes (118, 118', 118") médianes du premier, du deuxième et du troisième stacked-crystal-filters (300, 320,330) étant reliées directement entre elles et les électrodes (118, 118', 118") médianes étant mises à la terre.

26. Composant piézoélectrique suivant l'une des revendications 10 à 19,
**caractérisé en ce que** le composant piézoélectrique comprend au moins un balanced-filter (390), quatre dits stacked-crystal-filters (300, 300', 320, 320') dont les électrodes (118) médianes sont reliées directement entre elles et dont les électrodes (114) inférieures de deux de ces stacked-crystal-filters (300, 320, 300', 320') mentionnés en dernier sont formés et reliés directement entre eux comme décrit dans les revendications 10 à 19, de sorte que deux paires (370, 380) de stacked-crystal-filters sont formées et dans chaque paire (370, 380) de stacked-crystal-filters une électrode (220) supérieure est montée en entrée de signal et une électrode (220') supérieure est montée en sortie de signal.

27. Composant piézoélectrique suivant la revendication 26,
**caractérisé en ce que** les électrodes (118) médianes sont à la terre.

28. Composant piézoélectrique suivant l'une des revendications 10 à 27,
**caractérisé en ce que**, dans au moins l'un des stacked-crystal-filter (300, 320) du composant, la première électrode (114), la première couche (116) piézoélectrique, l'électrode (118) médiane, la deuxième couche (200) piézoélectrique et l'électrode (220) supérieure forment une pile (60) de couches dont l'épaisseur correspond à peu près à la demi-longueur d'onde de l'oscillation mécanique du stacked-crystal-filter (300, 320).
